# EUROPEAN PATENT APPLICATION

(11) **EP 1 103 827 A1**
(43) Date of publication of application: **30.05.2001**
(21) Application number: 99954547.8
(22) Date of filing: 22.07.1999
(51) Int. Cl.: G01V 3/08, G01V 9/00

(54) **METHOD FOR DETERMINING A GEO-PATHOGENIC AREA FROM ANOMALIES IN THE EARTH'S ELECTROSTATIC FIELD IN RESIDENTIAL AREAS**

(30) Priority: 03.08.1998 RU 98114135
(71) Applicant: Umarov, Georgy Ramasanovich, Moscow, 117588 (RU); Boychenko, Vladimir Segeevich, Moscow, 117330 (RU); Umarov, Maksim Georgievich, Moscow, 117588 (RU)
(72) Inventor: Umarov, Georgy Ramasanovich, Moscow, 117588 (RU); Boychenko, Vladimir Segeevich, Moscow, 117330 (RU); Umarov, Maksim Georgievich, Moscow, 117588 (RU)
(74) Representative: Herrmann-Trentepohl, Werner, Dipl.-Ing.
(86) International application number: RU9900247
(87) International publication number: WO0008488

(57) **Abstract**

The methods provides for measuring the constant component and determining the sign of the electrostatic field intensity in an inhabited area, and comparing the measurement results with known background values. Unlike the known ones the method allows of determining the quantitative parameters of a geopathogenic zone with a view to taking a decision on placing limitation upon the human's residence time under above said conditions or to rule out such a residence whatever.

## Description

The present invention relates to geophysical prospecting, in particular, to methods for measuring the parameters of the terrestrial electrostatic field.

A prerequisite to the provision of the method involved resides in complex medico-biological studies that confirm a negative effect produced by terrestrial geopathogenic zones on living organisms, in particular, on humans, since it is common knowledge that the Earth which on the whole is charged negatively, is surrounded by a bulk positive charge that compensates the negative terrestrial charge (that is, the inhabited area is "penetrated" by an electrostatic field). The geopathogenic zones are the actual geophysical phenomenon which appear as extensive geophysical anomalies characterized by modified environmental parameters differing from the statistical average ones, that is, geomagnetic field, electrical conductance of soil, atmospheric geomagnetic fields, radioactivity level, and the like. There are observed within the geopathogenic zones some local areas (which rarely measure in excess of 20x20 sq.cm) that are capable of producing an extremely pathogenic effect. At present, it is biolocation that proves to be a single simple and readily available method of detecting and assessing the structure of geopathogenic zones. Biolocation is based on the ability of human beings (approximately ten percent of the population of the Earth) to response (with the aid of simple contrivances) to the gradients of weak physical field of both natural and artificial origin. Biolocation-based methods of detecting geopathogenic zones are known, being described in a monograph by A. P. Dubrov entitled "Terrestrial radiation and human health", Moscow, 1983 (in Russian) and carried into effect by the provision of a device (indicating pendulum) protected by RU Patent # 2,028,006 IPC G 01 V 9/00, 1986 and a device (runner) according to DE Patent # 3,806,435 IPC G 01 V 9/00, 1989. The method mentioned above is actually capable of detecting the sources of geopathogenic zones, such as underground waterfalls, water veins, geological faults (fractures) and is in fact an informative one establishing the presence of an anomaly. However, it is known commonly that apart from the aforesaid local structures within the limits of geopathogenic zones which are capable of producing most pathogenic effect on humans, there occur the areas featuring high energy level (the so-called "mantle" areas) and therefore capable of producing a favorable effect on human organism by replenishing its energy. This makes it especially urgent to determine quantitative and sign characteristics of geopathogenic zones which make possible differentiating anomalies according to the effect they produce on humans within the habitable area thereof. As has been stated before, one of the characteristics of geopathogenic zones is the fact that the values of the electrostatic field strength go beyond the limits of a normal range determined by an indirect (estimation) method against the results of medico-biological experiments.

One prior-art method of passive geophysical prospecting is known to be based on detecting the vertical constant component of an electrical potential of the lowest (surface) atmospheric layer (cf. US Patent # 4,945,310, NPC 324-334, 1989), said method being the closest to the hereinproposed one. The method consists in determining the potential between two points arranged on the vertical over the Earth's surface. Then the received signal is processed so as to discriminate fluctuations of the information-carrying constant component. Considering the strength of an electrostatic field as a measure of intensity thereof in the form of a power series (Taylor's), it becomes evident that there is determined in this case only the second and then following constant components (gradients) rather than the first constant component, that is, the afore-discussed rather complicated method allows of determining the electrostatic field anomalies caused only by natural terrestrial currents, but loses information about the potentials generated by static charges. The method is also not intended for detecting the sign characteristics of the field potential which is essential for detecting geopathogenic zones, since reversal of the sign of potential is also the evidence of an anomaly. Moreover, said method involves the use of stationary equipment, thus being unsuitable for obtaining on-line information about geopathogenic zones.

Thus the present invention is aimed at providing a method for expeditiously determining geopathogenic zones against the anomalies of the terrestrial electrostatic field observed in an inhabited area. Insofar as the applicants did not find a method of the same purpose that characterizes a combination of features common to those of features of the present invention, said invention is claimed as an analog-free one.

The aim of the invention is attained due to the fact that, according to the method proposed therein, there is measured the constant component of the electrostatic field intensity in the inhabited area under study in order to determine the sign of said constant component, whereupon the measured quantity is compared with a known range of background values, and the presence of a geopathogenic zone is judged against an excess of the measured quantity of the electrostatic field intensity over the limit values of said range of background values, and/or against the reversal of the sign of the measured quantity. Insofar as there exist at present no principal standards of permissible level of effects produced by electrostatic fields, there is adopted as the range of background values a range of 90 to 450 W/m obtained by indirect measurements using the contact method. Taking account of the fact the value of a background magnitude field intensity changes along with a change of the parameters of an inhabited area, its magnitude is to be corrected depending on the deviation of said parameters from the following data: atmospheric pressure, 760 mm Hg of the level of the World Ocean; ambient air temperature t = 17 to 25°C; normal atmospheric gas composition. Said magnitude may be corrected by e.g. decreasing the boundaries of said range in case of a lower pressure or a higher ambient air temperature.

The method can be carried into effect using heretofore-known means, such as electroscopes disclosed in RU Patents ## 2,071,071 and 2,083,990, IPC G 01 R 29/12, 1995 operating on the concept that an electrically conducting body introduced into an electrostatic field acquires a potential of a respective point of said field. The method proposed herein can also be realized with the aid of devices based on a direct use of Coulomb's law. Information obtained by such devices can readily be converted and analyzed using modern means for digital signal processing.

A block diagram of the apparatus is present in the appended Drawing. The instruments comprises a probe 1, a converter 2, a data analyzer 3, and a control console 4 with an indicating instrument 5.

The method proposed herein is carried into effect as follows.

The probe 1 is placed in the zone under study and data on the background field intensity are entered into the apparatus by, e.g., initial calibration of the data analyzer 3, which is readily attainable with the modern level of digital engineering. The indicating instrument 5 is to be so adjusted that it should present information about the electrostatic field intensity value going beyond the limits of said range, and about the reversal of the sign of said intensity. The indicating instrument may be further furnished with warning means, e.g. light or audible ones.

The proposed method allows not only detecting geopathogenic zones but also determining the degree of their health hazards. The method is suitable both for individual use in order to place limitation upon the human's residence time in the geopathogenic zones or to rule out such a residence whatever and for mapping an inhabited area with a view to developing methods of protection against the pathogenic effect of the environment.

## Claims

1. A method for determining a geopathogenic zone against the anomalies of the terrestrial electrostatic field observed in an inhabited area, said method consisting in tat there is measured the constant component of the electrostatic field intensity and the sign of said component is determined at at least one of the points of the inhabited area, whereupon data thus obtained are compared with a range of background values, and the presence of a geopathogenic zone is judged against an excess of the measured quantity of the electrostatic field intensity over the limit values of said range of background values, and/or against the reversal of the sign of the measured quantity.

2. The method of claim 1, CHARACTERIZED in that adopted as the range of background values is a range of from 90 to 450 W/m.

3. The method of claim 1, CHARACTERIZED in that the range of background values of the constant component of field intensity is corrected when the parameters of an inhabited area deviate from normal conditions.
